# EUROPEAN PATENT APPLICATION

(11) **EP 1 933 396 A1**
(43) Date of publication of application: **18.06.2008**
(21) Application number: 06780803.0
(22) Date of filing: 05.07.2006
(51) Int. Cl.: H01L 51/50, C09K 11/06, H05B 33/10

(54) **ORGANIC ELECTROLUMINESCENT ELEMENT USING POLYARYLAMINE**

(30) Priority: 08.09.2005 JP 2005260562
(71) Applicant: Idemitsu Kosan Co., Ltd., Chiyoda-ku Tokyo 100-8321 (JP)
(72) Inventor: INOUE, Tetsuya, Sodegaura-shi, Chiba 299-0293 (JP); KONDO, Hirofumi, Sodegaura-shi, Chiba 299-0293 (JP); JUNKE, Tadanori, Sodegaura-shi, Chiba 299-0293 (JP)
(74) Representative: Gille Hrabal Struck Neidlein Prop Roos
(86) International application number: PCT/JP2006/313427
(87) International publication number: WO 2007/029410

(57) **Abstract**

In an organic electroluminescence device in which one or more organic compound layer is interposed between a pair of electrodes constituted from an anode and a cathode, the organic compound layer comprises a hole transporting layer and/or a hole injecting layer, and polyarylamine having a specific structure is contained in the above hole transporting layer and/or hole injecting layer, whereby the organic electroluminescence device obtained by using polyaryLamine is provided. In particular, materialized is the organic electroluminescence device in which a production process is simplified and which is increased in a size of a screen and a improved in device performance.

## Description

### BACKGROUND OF THE INVENTION

The present invention relates to an organic electroluminescence device field, specifically to an organic electroluminescence device prepared by using a specific polymer in a hole injecting layer or a hole transporting layer and using a specific low-molecular material in an emitting layer.
The organic electroluminescence device of the present invention can be used for flat luminous bodies such as flat panel displays and the like, copying machines, printers, backlights for liquid crystal displays or light sources for measuring meters and the like, display boards, marker lamps and the like.

### RELATED ART

An organic electroluminescence device (hereinafter "electroluminescence" shall be abbreviated as EL) is prepared by a wet method such as spin coating, ink jet coating and the like using polymers such as polyolefin, soluble PPV (poly(p-phenylenevinylene)) and the like and a dry method such as vacuum vapor deposition and the like using low-molecular materials. In particular, it is relatively easier rather in the wet method among the preparing methods described above to increase an area of a display screen, and researches for preparing organic EL devices using polymer materials are energetically promoted. In recent years, it is disclosed that an organic EL device having plural organic thin film layers has been prepared by a wet method, and both of a hole injecting layer and an emitting layer are constituted from polymer materials in this patent (refer to, for example, a patent document 1).
However, polymer materials have molecular weight distribution, and the defects that it is difficult to refine them and that they are less liable to be increased in a purity are involved therein. When using them for an emitting layer in an organic EL device, problems have been involved in a color purity, a luminous efficiency, a luminance and a luminance half life of the emitting color.
On the other hand, low-molecular materials are readily increased in a purity by publicly known methods, and when using them for an emitting layer in an organic EL device, it is given as the advantages thereof that they are excellent in a color purity, a luminous efficiency and a luminance of the light emitting color and extended in a luminance half life thereof as compared with the polymers. However, the good light emitting performances have not been shown in some cases depending on materials constituting a hole injecting layer or a hole transporting layer which is adjacent to an emitting layer.
Patent document 1: International Publication No. WO2004/84260

### SUMMARY OF THE INVENTION

The present invention has been made in order to solve the problems described above, and an object of the present invention is to provide an organic electroluminescence device prepared by using polyarylamine, specifically to provide an organic electroluminescence device in which a production process is simplified and which is increased in a size of a screen and improved in a device performance.

Intensive researches repeated by the present inventors in order to achieve the object described above have resulted in finding that the object described above is achieved by an organic EL device in which one or more organic compound layer comprising at least an emitting layer is interposed between a pair of electrodes constituted from an anode and a cathode, wherein the organic compound layer comprises a hole transporting layer and/or a hole injecting layer, and polyarylamine represented by Formula (1) shown below is contained in the above hole transporting layer and/or hole injecting layer, and thus the present invention has been completed. 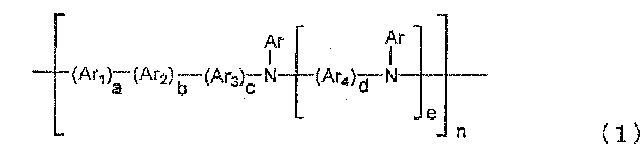 In Formula (1), Ar each is independently a substituted or non-substituted aryl group having 6 to 40 carbon atoms or a substituted or non-substituted heteroaryl group having 3 to 40 carbon atoms; Ar₁ to Ar₄ each are independently a substituted or non-substituted divalent arylene group having 6 to 40 carbon atoms; a, b, c and d each are independently an integer of 1 to 2; e is an integer of 0 to 2; and n is an integer of 3 or more.

Further, the present invention provides the organic electroluminescence device described above in which the hole transporting layer and/or hole injecting layer described above contains principally polyarylamine described above, the organic electroluminescence device described above in which the emitting layer is selected principally from an anthracene derivative, a pyrene derivative and/or a fluorene derivative, the organic electroluminescence device described above in which a dopant is contained in the emitting layer, the organic electroluminescence device described above in which the hole transporting layer and/or the hole injecting layer are formed by a wet method and in which the emitting layer is formed by the wet method and the organic electroluminescence device described above in which the hole transporting layer and/or the hole injecting layer are formed by the wet method and in which the emitting layer is formed by vapor deposition.

In the organic electroluminescence device having an emitting layer comprising a low-molecular material, polyarylamine having a specific structure is used in a hole transporting and injecting layer, whereby a device performance has been able to be enhanced.

### BRIEF DESCRIPTION OF THE DRAWINGS

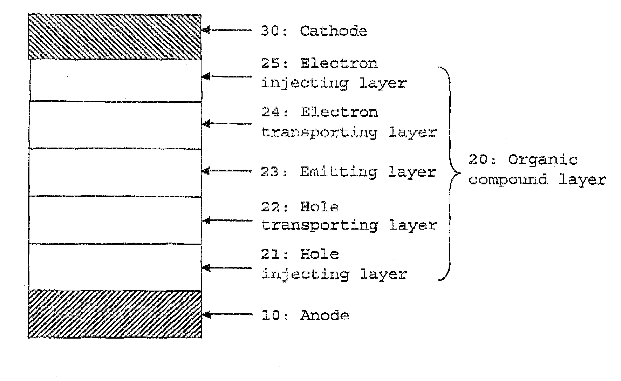

Fig. 1 is a cross section showing the embodiment of the organic EL device according to the present invention.

### EXPLANATIONS OF THE CODES

10 Anode
20 Organic compound layer
21 Hole injecting layer
22 Hole transporting layer
23 Emitting layer
24 Electron transporting layer
25 Electron injecting layer
30 Cathode

### BEST MODE FOR CARRYING OUT THE INVENTION

The organic electroluminescence device of the present invention is an organic EL device in which one or more organic compound layer comprising at least an emitting layer is interposed between a pair of electrodes constituted from an anode and a cathode, wherein the organic compound layer comprises a hole transporting layer and/or a hole injecting layer, and polyarylamine represented by Formula (1) shown below is contained in the above hole transporting layer and/or hole injecting layer. 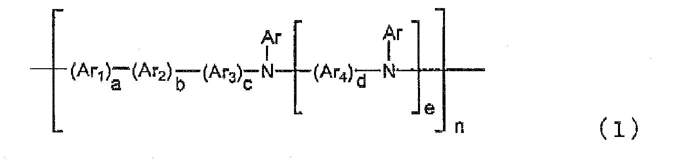 In Formula (1), Ar is a substituted or non-substituted aryl group having 6 to 40 carbon atoms or a substituted or non-substituted heteroaryl group having 3 to 40 carbon atoms; Ar₁ to Ar₄ each are independently a substituted or non-substituted divalent arylene group having 6 to 40 carbon atoms; a, b, c and d each are independently an integer of 1 to 2; e is an integer of 0 to 2; and n is an integer of 3 or more.

In Formula (1), the examples of the aryl group having 6 to 40 of the number of carbon atoms forming the aromatic ring represented by Ar include phenyl, 2-biphenylyl, 3-biphenylyl, 4-biphenylyl, terphenylyl, 3,5-diphenylylphenyl, 3,5-di(1-naphthyl) phenyl, 3,5-di(2-naphthyl)phenyl, 3,4-diphenylphenyl, pentaphenylphenyl, 4-(2,2-diphenylvinyl)phenyl, 4-(1,2,2-triphenylvinyl)phenyl, fluorenyl, 1-naphthyl, 2-naphthyl, 4-(1-naphthyl)phenyl, 4-(2-naphthyl)phenyl, 3-(1-naphthyl)phenyl, 3-(2-naphthyl)phenyl, 9-anthryl, 2-anthryl, 9-phenanthryl, 1-pyrenyl, chrysenyl, naphthacenyl, coronyl and the like.

In Formula (1), the examples of the heteroaryl group having 3 to 40 ring carbon atoms represented by Ar include 1-pyrrolyl, 2-pyrrolyl, 3-pyrrolyl, pyrazinyl, pyrimidyl, pyridazyl, 2-pyridinyl, 3-pyridinyl, 4-pyridinyl, 1-indolyl, 2-indolyl, 3-indolyl, 4-indolyl, 5-indolyl, 6-indolyl, 7-indolyl, 1-isoindolyl, 2-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-phenanthridinyl, 2-phenanthridinyl, 3-phenanthridinyl, 4-phenanthridinyl, 6-phenanthridinyl, 7-phenanthridinyl, 8-phenanthridinyl, 9-phenanthridinyl, 10-phenanthryldinyl, 1-acridinyl, 2-acridinyl, 3-acridinyl, 4-acridinyl, 9-acridinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthrolin-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phonanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 10-phenothiazinyl, 1-phenoxazinyl, 2-phenoxazinyl, 3-phenoxazinyl, 4-phenoxazinyl, 10-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl-1-indolyl, 4-t-butyl-1-indolyl, 2-t-butyl-3-indolyl, 4-t-butyl-3-indolyl and the like.

In Formula (1), the examples of the divalent arylene group having 6 to 40 ring carbon atoms represented by Ar₁ to Ar₄ include groups having a structure obtained by removing any hydrogens from the examples of the aryl group having 6 to 40 ring carbon atoms represented by Ar.

In Formula (1), substituents for the aryl group, the arylene group and the heteroaryl group each represented by Ar and Ar₁ to Ar₄ include, for example, an alkyl group (it has preferably 1 to 20 carbon atoms, more preferably 1 to 12 carbon atoms and particularly preferably 1 to 8 carbon atoms and includes, for example, methyl, ethyl, isopropyl, t-butyl, n-octyl, n-decyl, n-hexadecyl, cyclopropyl, cyclopentyl, cyclohexyl and the like), an alkenyl group (it has preferably 2 to 20 carbon atoms, more preferably 2 to 12 carbon atoms and particularly preferably 2 to 8 carbon atoms and includes, for example, vinyl, allyl, 2-butenyl, 3-pentenyl and the like), an alkynyl group (it has preferably 2 to 20 carbon atoms, more preferably 2 to 12 carbon atoms and particularly preferably 2 to 8 carbon atoms carbon atoms and includes, for example, propargyl, 3-pentynyl and the like), an amino group (it has preferably 0 to 20 carbon atoms, more preferably 0 to 12 carbon atoms and particularly preferably 0 to 6 carbon atoms and includes, for example, amino, methylamino, dimethylamino, diethylamino, diphenylamino, dibenzylamino and the like), an alkoxy group (it has preferably 1 to 20 carbon atoms, more preferably 1 to 12 carbon atoms and particularly preferably 1 to 8 carbon atoms and includes, for example, methoxy, ethoxy, butoxy and the like), an aryloxy group (it has preferably 6 to 20 carbon atoms, more preferably 6 to 16 carbon atoms and particularly preferably 6 to 12 carbon atoms and includes, for example, phenyloxy, 2-naphthyloxy and the like), an acyl group (it has preferably 1 to 20 carbon atoms, more preferably 1 to 16 carbon atoms and particularly preferably 1 to 12 carbon atoms and includes, for example, acetyl, benzoyl, formyl, pivaloyl and the like), an alkoxycarbonyl group (it has preferably 2 to 20 carbon atoms, more preferably 2 to 16 carbon atoms and particularly preferably 2 to 12 carbon atoms and includes, for example, methoxycarbonyl, ethoxycarbonyl and the like), an aryloxycarbonyl group (it has preferably 7 to 20 carbon atoms, more preferably 7 to 16 carbon atoms and particularly preferably 7 to 10 carbon atoms and includes, for example, phenyloxycarbonyl and the like), an acyloxy group (it has preferably 2 to 20 carbon atoms, more preferably 2 to 16 carbon atoms and particularly preferably 2 to 10 carbon atoms and includes, for example, acetoxy, benzoyloxy and the like), an acylamino group (it has preferably 2 to 20 carbon atoms, more preferably 2 to 16 carbon atoms and particularly preferably 2 to 10 carbon atoms and includes, for example, acetylamino, benzoylamino and the like), an alkoxycarbonylamino group (it has preferably 2 to 20 carbon atoms, more preferably 2 to 16 carbon atoms and particularly preferably 2 to 12 carbon atoms and includes, for example, methoxycarbonylamino and the like), an aryloxycarbonylamino group (it has preferably 7 to 20 carbon atoms, more preferably 7 to 16 carbon atoms and particularly preferably 7 to 12 carbon atoms and includes, for example, phenyloxycarbonylamino and the like), a sulfonylamino group (it has preferably 1 to 20 carbon atoms, more preferably 1 to 16 carbon atoms and particularly preferably 1 to 12 carbon atoms and includes, for example, methanesulfonylamino, benzenesulfonylamino and the like), a sulfamoyl group (it has preferably 0 to 20 carbon atoms, more preferably 0 to 16 carbon atoms and particularly preferably 0 to 12 carbon atoms and includes, for example, sulfamoyl, methylsulfamoyl, dimethylsulfamoyl, phenylsulfamoyl and the like), a carbamoyl group (it has preferably 1 to 20 carbon atoms, more preferably 1 to 16 carbon atoms and particularly preferably 1 to 12 carbon atoms and includes, for example, carbamoyl, methylcarbamoyl, diethylcarbamoyl, phenylcarbamoyl and the like), an alkylthio group (it has preferably 1 to 20 carbon atoms, more preferably 1 to 16 carbon atoms and particularly preferably 1 to 12 carbon atoms and includes, for example, methylthio, ethylthio and the like), an arylthio group (it has preferably 6 to 20 carbon atoms, more preferably 6 to 16 carbon atoms and particularly preferably 6 to 12 carbon atoms and includes, for example, phenylthio and the like), a sulfonyl group (it has preferably 1 to 20 carbon atoms, more preferably 1 to 16 carbon atoms and particularly preferably 1 to 12 carbon atoms and includes, for example, mesyl, tosyl and the like), a sulfinyl group (it has preferably 1 to 20 carbon atoms, more preferably 1 to 16 carbon atoms and particularly preferably 1 to 12 carbon atoms and includes, for example, methanesulfinyl, benznesulfinyl and the like), a ureido group (it has preferably 1 to 20 carbon atoms, more preferably 1 to 16 carbon atoms and particularly preferably 1 to 12 carbon atoms and includes, for example, ureido, methylureido, phenylureido and the like), a phosphoric amide group (it has preferably 1 to 20 carbon atoms, more preferably 1 to 16 carbon atoms and particularly preferably 1 to 12 carbon atoms and includes, for example, diethylphosphoric amide, phenylphosphoric amide and the like), a hydroxy group, a mercapto group, a halogen atom (for example, a fluorine atom, a chlorine atom, a bromine atom and an iodine atom), a cyano group, a sulfo group, a carboxyl group, a nitro group, a hydroxamic acid group, a sulfino group, a hydrazino group, an imino group, a heterocyclic group (it has preferably 1 to 30 carbon atoms, more preferably 1 to 12 carbon atoms, and a hetero atom includes, for example, a nitrogen atom, an oxygen atom and a sulfur atom; to be specific, it includes, for example, imidazolyl, pyridyl, quinolyl, furyl, thienyl, piperidyl, morpholino, benzoxazolyl, benzimidazolyl, benzothiazolyl, carbazolyl and the like), a silyl group (it has preferably 3 to 40 carbon atoms, more preferably 3 to 30 carbon atoms and particularly preferably 3 to 24 carbon atoms and includes, for example, trimethylsilyl, triphenylsilyl and the like) and the like. The above substituents may be further substituted. When they have two or more substituents, they may be the same or different. If possible, they may be combined with each other to form rings.

The specific examples of the polyarylamine represented by Formula (1) according to the present invention shall be shown below, but they shall not be restricted to these compounds shown as the examples.

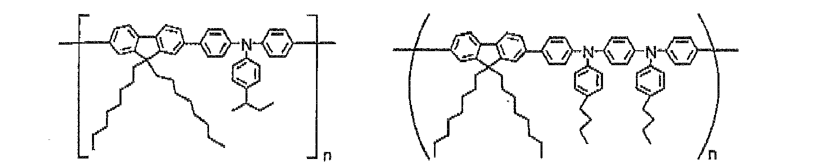

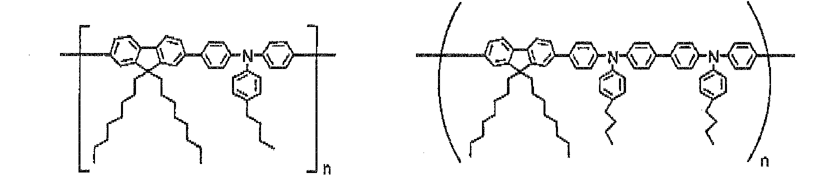

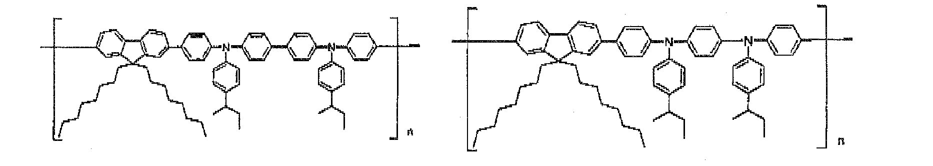

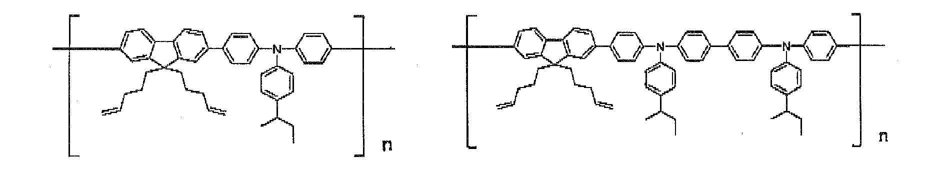

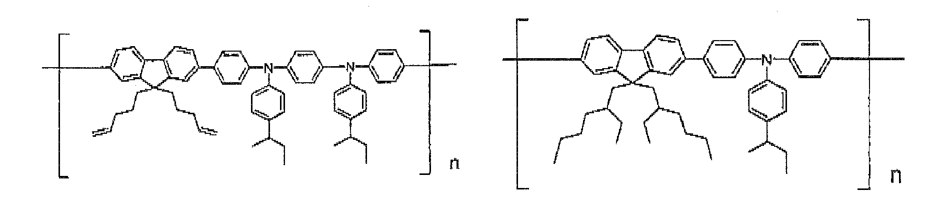

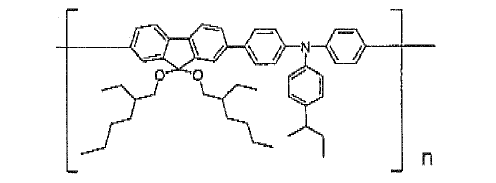

The polyarylamine of the present invention is preferably a material for an organic EL device and particularly suited to a hole transporting material for an organic EL device and a hole injecting material for an organic EL device.
Further, the polyarylamine of the present invention can be used either as a hole injecting material or as a hole transporting material, and preferably used are a compound having a phenylenediamine skeleton as a hole injecting material and a compound having a diphenylenediamine skeleton as a hole transporting material.
The hole transporting material and the hole injecting material for the organic electroluminescence device of the present invention are preferably used for forming a film by a wet method.

The emitting layer of the organic electroluminescence device according to the present invention is selected principally from an anthracene derivative, a pyrene derivative and/or a fluorene derivative. The suited anthracene derivative, pyrene derivative and/or fluorene derivative shall be shown below. 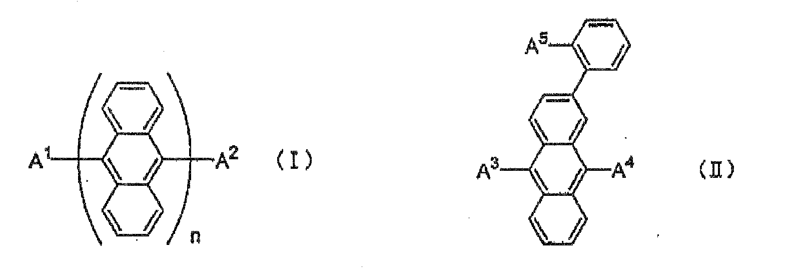 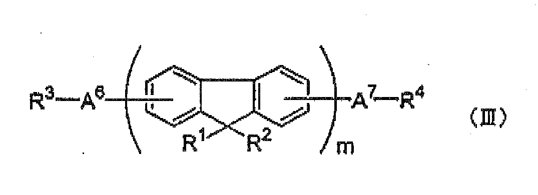 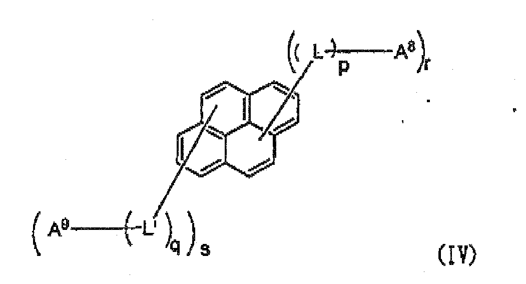 In Formula (I), A¹ and A² are an aryl group having 6 to 50 ring carbon atoms which may have a substituent or a heteroaryl group having 5 to 50 of the number of atoms forming a ring which may have a substituent; A¹ and A² are not the same; and n is an integer of 1 or 2.

In Formula (II), A³ to A⁵ are an aryl group having 6 to 50 ring carbon atoms which may have a substituent or a heteroaryl group having 5 to 50 ring atoms which may have a substituent; and A³ to A⁵ may be the same as or different from each other.

In Formula (III), A⁶ and A⁷ are anthracenylene or pyrenylene; A⁶ and A⁷ may be the same or different; m is an integer of 1 to 3; R¹ and R² may be the same or different and are hydrogen or an alkyl group having 1 to 10 carbon atoms; R³ and R⁴ may be the same or different and are hydrogen, a phenyl group substituted with an alkyl group having 1 to 6 carbon atoms or a biphenyl group.
Preferably, A⁶ and A⁷ are the same; R¹ and R² are the same and an alkyl group having 4 to 10 carbon atoms; and R³ and R⁴ are the same.

In Formula (IV), L and L' each are a substituted or non-substituted phenylene group, a non-substituted naphthalenylene group, a substituted or non-substituted fluorenylene group or a substituted or non-substituted dibenzosilolylene group; A⁸ and A⁹ each are a substituted or non-substituted aromatic group having 6 to 50 ring carbon atoms; p and q are an integer of 0 to 2; r is an integer of 1 to 4; and s is an integer of 0 to 4.

When preparing the emitting layer of the organic electroluminescence device according to the present invention, the anthracene derivative, the pyrene derivative and/or the fluorene derivative each described above can be used as a host material. Further, a styrylamine compound and/or an arylamine compound are preferably added as a dopant contained in the emitting layer.
The styrylamine compound is preferably a compound represented by the following Formula (1):

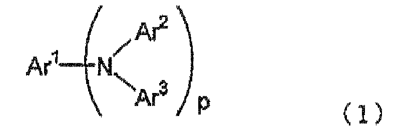

(wherein Ar¹ is a group selected from a phenyl group, a biphenyl group, a terphenyl group, a stilbene group and a distyrylaryl group; Ar² and Ar³ each are a hydrogen atom or an aromatic group having 6 to 20 carbon atoms, and Ar¹ to Ar³ may be substituted; p is an integer of 1 to 4; and more preferably, at least one of Ar² and Ar³ is substituted with a styryl group).

In this regard, the aromatic group having 6 to 20 carbon atoms includes phenyl, naphthyl, anthranyl, phenanthryl, terphenyl and the like.

The arylamine compound is preferably a compound represented by the following Formula (2): 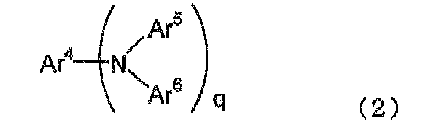 (wherein Ar⁴ to Ar⁶ are a substituted or non-substituted aryl group having 5 to 40 ring atoms; and q is an integer of 1 to 4).

In this regard, the aryl group having 5 to 40 ring atoms includes, for example, phenyl, naphthyl, chrysenyl, naphthacenyl, anthranyl, phenanthryl, pyrenyl, coronyl, biphenyl, terphenyl, pyrrolyl, furanyl, thiophenyl, benzothiophenyl, oxadiazolyl, diphenylanthranyl, indolyl, carbazolyl, pyridyl, benzoquinolyl, fluoranthenyl, acenaphthofluoranthenyl, stilbene and the like. Preferred substituents for the aryl group include an alkyl group having 1 to 6 carbon atoms (ethyl, methyl, isopropyl, n-propyl, s-butyl, t-butyl, pentyl, hexyl, cyclopentyl, cyclohexyl and the like), an alkoxy group having 1 to 6 carbon atoms (ethoxy, methoxy, isopropoxy, n-propoxy, s-butoxy, t-butoxy, pentoxy, hexyloxy, cyclopentoxy, cyclohexyloxy and the like), an aryl group having 5 to 40 ring atoms, an amino group substituted with an aryl group having 5 to 40 ring atoms, an ester group having an aryl group having 5 to 40 ring atoms, an ester group having an alkyl group having 1 to 6 carbon atoms, a cyano group, a nitro group, a halogen atom and the like.

The emitting layer of the organic electroluminescence device according to the present invention can be formed from the light emitting materials described above not only by vapor deposition but also by a wet method. Coating methods such as a dipping method, a spin coating method, a casting method, a bar coating method, a roll coating method and the like can be applied to forming a film of the emitting layer by the wet method and forming a film of the hole transporting material and the hole injecting material by the wet method. The examples of solvents used for the above wet film formations include halogen base hydrocarbon solvents such as dichloromethane, dichloroethane, chloroform, carbon tetrachloride, tetrachloroethane, trichloroethane, chlorobenzene, dichlorobenzene, chlorotoluene and the like, ether base solvents such as dibutyl ether, tetrahydrofuran, dioxane, anisole and the like, alcohol base solvents such as methanol, ethanol, propanol, butanol, pentanol, hexanol, cyclohexanol, methyl cellosolve, ethyl cellosolve, ethylene glycol and the like, hydrocarbon base solvents such as benzene, toluene, xylene, ethylbenzene, tetralin, dodecylbenzene, hexane, octane, decane and the like and ester base solvents such as ethyl acetate, butyl acetate, amyl acetate and the like. Among them, the halogen base hydrocarbon solvents, the hydrocarbon base solvents and the ether base solvents are preferred. The above solvents may be used alone or in a mixture of plural kinds thereof. The solvents which can be used shall not be restricted to them.

The following constitutions can be shown as the device constitution of the organic EL device. However, it shall not be restricted to them.
(1) Anode/emitting layer/cathode
(2) Anode/hole injecting layer/emitting layer/cathode
(3) Anode/emitting layer/electron injecting layer/cathode
(4) Anode/hole injecting layer/emitting layer/electron injecting layer/cathode
(5) Anode/organic semiconductor layer/emitting layer/cathode
(6) Anode/organic semiconductor layer/electron blocking layer/emitting layer/cathode
(7) Anode/organic semiconductor layer/emitting layer/adhesion improving layer/cathode
(8) Anode/hole injecting layer/hole transporting layer/emitting layer/electron injecting layer/cathode
(9) anode/insulating layer/emitting layer/insulating layer/cathode,
(10) anode/inorganic semiconductor layer/insulating layer/emitting layer/insulating layer/cathode
(11) anode/organic semiconductor layer/insulating layer/emitting layer/insulating layer/cathode,
(12) anode/insulating layer/hole injecting layer/hole transporting layer/emitting layer/insulating layer/cathode and
(13) anode/insulating layer/hole injecting layer/hole transporting layer/emitting layer/electron injecting layer/cathode
   Among them, usually the constitution of (8) is preferably used.

The hole injecting and transporting layer is a layer for assisting injection of a hole into the emitting layer to transport it to the emitting region, and it has a large hole mobility and shows usually as small ionization energy as 5.6 eV or less. A material which transports a hole to the emitting layer at a lower electric field strength is preferred for the above hole injecting and transporting layer, and more preferred is a material in which a mobility of a hole is at least 10⁻⁴ cm²/V·second in applying an electric field of, for example, 10⁴ to 10⁶ V/cm.

A material for forming the hole injecting and transporting layer contains preferably the polyarylamine of the present invention. However, it shall not specifically be restricted as long as it has the preferred properties described above, and capable of being used are optional materials selected from materials which have so far conventionally been used as charge transporting materials for holes in photoconductive materials and publicly known materials which are used for a hole injecting layer in an organic EL device. It includes, for example, aromatic tertiary amines, hydrazone derivatives, carbazole derivatives, triazole derivatives, imidazole derivatives, polyvinylcarbazole, polyethylenedioxythiophene·polysulfonic acid (PEDOT·PSS) and the like. Further, the specific examples thereof include triazole derivatives (refer to U.S. Patent No. 3,112,197 and the like), oxadiazole derivatives (refer to U.S. Patent No. 3,189,447 and the like), imidazole derivatives (refer to Japanese Patent Publication No. 16096/1962 and the like), polyarylalkane derivatives (refer to U.S. Patent No. 3,615,402, ditto No. 3,820,989 and ditto No. 3,542,544, Japanese Patent Publication No. 555/1970 and ditto No. 10983/1976 and Japanese Patent Application Laid-Open No. 93224/1976, ditto No. 17105/1980, ditto No. 4148/1981, ditto No. 108667/1980, ditto No. 156953/1980 and ditto No. 36656/1981 and the like), pyrazoline derivatives and pyrazolone derivatives (refer to U.S. Patent No. 3,180,729 and ditto No. 4,278,746 and Japanese Patent Application Laid-Open No. 88064/1980, ditto No. 88065/1980, ditto No. 105537/1974, ditto No. 51086/1980, ditto No. 80051/1981, ditto No. 88141/1981, ditto No. 45545/1982, ditto No. 112637/1979 and ditto No. 74546/1980 and the like), phenylenediamine derivatives (refer to U.S. Patent No. 3,615,404, Japanese Patent Publication No. 10105/1976, ditto No. 3712/1971 and ditto No. 25336/1972 and Japanese Patent Application Laid-Open No. 53435/1980, ditto No. 110536/1979 and ditto No. 119925/1979 and the like), arylamine derivatives (refer to U.S. Patent No. 3,567,450, ditto No. 3,180,703, ditto No. 3,240,597, ditto No. 3,658,520, ditto No. 4,232,103, ditto No. 4,175,961 and ditto No. 4,012,376, Japanese Patent Publication No. 35702/1974 and ditto No. 27577/1964, Japanese Patent Application Laid-Open No. 144250/1980, ditto No. 119132/1981 and ditto No. 22437/1981 and German Patent No. 1,110,518 and the like), amino-substituted chalcone derivatives (refer to U.S. Patent No. 3,526,501 and the like), oxazole derivatives (disclosed in U.S. Patent No. 3,257,203 and the like), styrylanthracene derivatives (refer to Japanese Patent Application Laid-Open No. 46234/1981 and the like), fluorenone derivatives (refer to Japanese Patent Application Laid-Open No. 110837/1979 and the like), hydrazone derivatives (refer to U.S. Patent No. 3,717,462, Japanese Patent Application Laid-Open No. 59143/1979, ditto No. 52063/1980, ditto No. 52064/1980, ditto No. 46760/1980, ditto No. 85495/1980, ditto No. 11350/1982 and ditto No. 148749/1982 and ditto No. 311591/1990 and the like), stilbene derivatives (refer to Japanese Patent Application Laid-Open No. 210363/1986, ditto No. 228451/1986, ditto No. 14642/1986, ditto No. 72255/1986, ditto No. 47646/1987, ditto No. 36674/1987, ditto No. 10652/1987, ditto No. 30255/1987, ditto No. 93455/1985, ditto No. 94462/1985, ditto No. 174749/1985 and ditto No. 175052/1985 and the like), silazane derivatives (U.S. Patent No. 4,950,950), polysilane base (Japanese Patent Application Laid-Open No. 204996/1990), aniline base copolymers (Japanese Patent Application Laid-Open No. 282263/1990) and electroconductive high molecular oligomers (particularly thiophene oligomers) disclosed in Japanese Patent Application Laid-Open No. 211399/1989.

The compounds described above can be used as the material for the hole injecting layer, and preferably used are porphyrin compounds, aromatic tertiary amine compounds and styrylamine compounds (refer to U.S. Patent No. 4,127,412 and Japanese Patent Application Laid-Open No. 27033/1978, ditto No. 58445/1979, ditto No. 149634/1979, ditto No. 64299/1979, ditto No. 79450/1980, ditto No. 144250/1980, ditto No. 119132/1981, ditto No. 295558/1986, ditto No. 98353/1986 and ditto No. 295695/1988 and the like), and the aromatic tertiary amine compounds are particularly preferably used.

Further, capable of being given are compounds having two fused aromatic rings in a molecule described in U.S. Patent No. 5,061,569, for example, 4,4'-bis(N-(1-naphthyl)-N-phenylamino)biphenyl (hereinafter abbreviated as NPD) and 4,4',4"-tris(N-(3-methylphenyl)-N-phenylamino)triphenylamine (hereinafter abbreviated as MTDATA) in which three triphenylamine units are connected in the form of a star burst type disclosed in Japanese Patent Application Laid-Open No. 308688/1992.
Further, inorganic compounds such as p type Si, p type SiC and the like in addition to the aromatic dimethylidene base compounds can also be used as the material for the hole injecting layer.

The hole injecting and transporting layer may be constituted by one layer comprising at least one of the materials described above or may be a layer obtained by laminating hole injecting and transporting layers comprising different kinds of compounds.

The organic semiconductor layer is a layer for assisting injection of a hole or injection of an electron into the emitting layer, and the layer having a conductance of 10⁻¹⁰ S/cm or more is suited. Capable being used as a material for the above organic semiconductor layer are conductive oligomers such as thiophene-containing oligomers and arylamine-containing oligomers disclosed in Japanese Patent Application Laid-Open No. 193191/1996 and conductive dendrimers such as arylamine-containing dendrimers.

The electron injecting layer is a layer for assisting injection of an electron into the emitting layer, and it has a large electron mobility. Also, the adhesion improving layer is a layer comprising particularly a material having a good adhesive property with the cathode in the above electron injecting layer. Materials used for the electron injecting layer are suitably metal complexes of 8-hydroxyquinoline and derivatives thereof and oxadiazole derivatives.

The specific examples of the metal complexes of 8-hydroxyquinoline or the derivatives thereof include metal chelate oxynoid compounds containing chelates of oxine (in general, 8-quinolinol or 8-hydroxyquinoline). For example, tris(8-quinolinol)aluminum (Alq) can be used for the electron injecting layer.
Also, the oxadiazole derivative includes an electron transfer compound represented by the following formula:

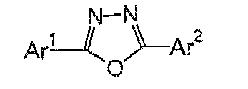

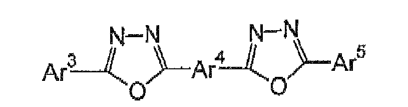

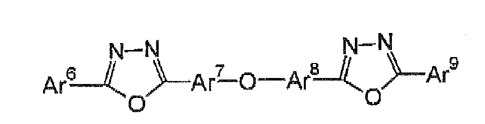

(wherein Ar^{1'}, Ar^{2'}, Ar^{3'}, Ar^{5'}, Ar^{6'} and Ar^{9'} each represent a substituted or non-substituted aryl group, and they may be the same as or different from each other; Ar^{4'}, Ar^{7'} and Ar^{8'} represent a substituted or non-substituted arylene group, and they may be the same as or different from each other).
In this regard, the aryl group includes phenyl, biphenyl, anthranyl, perylenyl, pyrenyl and the like. The arylene group includes phenylene, naphthylene, biphenylene, anthranylene, perylenylene, pyrenylene and the like. Further, the substituent is preferably an alkyl group having 1 to 10 carbon atoms, an alkoxy group having 1 to 10 carbon atoms or a cyano group. The above electron transfer compound is preferably a compound having a thin film forming property.

The following compounds can be given as the specific examples of the above electron transfer compound.

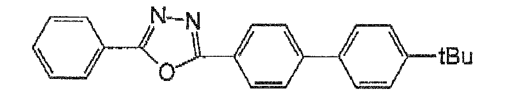

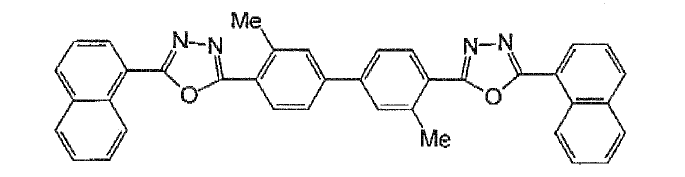

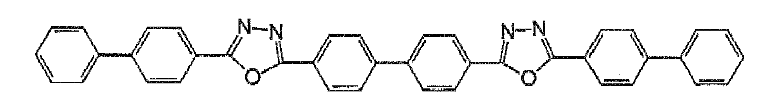

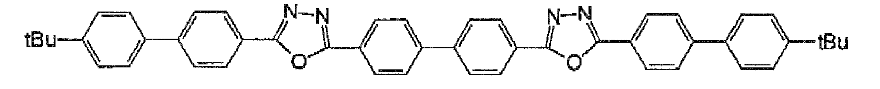

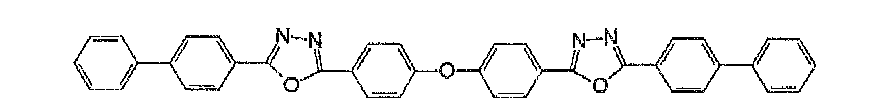

In the organic EL device, an electron injecting layer constituted from an insulator and a semiconductor may further be provided between the cathode and the organic layer, and an electric current can effectively be prevented from leaking to enhance the electron injecting property.
Preferably used as the above insulator is at least one metal compound selected from the group consisting of alkali metal chalcogenides, alkali earth metal chalcogenides, halides of alkali metals and halides of alkali earth metals. If the electron injecting layer is constituted from the above alkali metal chalcogenides and the like, it is preferred from the viewpoint that the electron injecting property can further be enhanced. To be specific, the preferred alkali metal chalcogenides include, for example, Li₂O, K₂O, Na₂S, Na₂Se and Na₂O, and the preferred alkali earth metal chalcogenides include, for example, CaO, BaO, SrO, BeO, BaS and CaSe. Also, the preferred halides of alkali metals include, for example, LiF, NaF, KF, LiCl, KCl, NaCl and the like. Further, the preferred halides of alkali earth metals include, for example, fluorides such as CaF₂, BaF₂, SrF₂, MgF₂ and BeF₂ and halides other than the fluorides.

The semiconductor includes a single kind of oxides, nitrides or nitride oxides containing at least one element of Ba, Ca, Sr, Yb, Al, Ga, In, Li, Na, Cd, Mg, Si, Ta, Sb and Zn or combinations of two or more kinds thereof. The inorganic compound constituting the electron transporting layer is preferably a microcrystalline or amorphous insulating thin film. If the electron transporting layer is constituted from the above insulating thin film, the more homogeneous thin film is formed, and therefore pixel defects such as dark spots and the like can be reduced. The above inorganic compound includes the alkali metal chalcogenides, the alkali earth metal chalcogenides, the halides of alkali metals and the halides of alkali earth metals each described above.

The organic EL device is liable to cause pixel defects due to leak and short since an electric field is applied to a ultrathin film. In order to prevent the above matter, an insulating thin film layer is preferably interposed between a pair of the electrodes.
A material used for the insulating layer includes, for example, aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, vanadium oxide and the like, and mixtures and laminates thereof may be used as well.

A film thickness of the respective organic layers constituting the organic thin film layer in the organic EL device of the present invention shall not specifically be restricted. In general, if the film thickness is too small, defects such as pinholes and the like are liable to be caused. On the other hand, if it is too large, a high voltage has to be applied to deteriorate the efficiency, and therefore it falls usually in a range of several nm to 1 µm.

An anode in the organic EL device assumes a role of injecting a hole into the hole injecting/transporting layer or the emitting layer, and it is effective to provide the anode with a work function of 4.5 eV or more. The specific examples of a material for the anode include tin-doped indium oxide alloy (ITO), tin oxide (NESA), gold, silver, platinum, copper and the like.
The anode can be prepared by forming a thin film from the above electrode substances by a method such as a vapor deposition method, a sputtering method and the like.
When light emitted from the emitting layer is taken out from the anode, a transmittance of light in the anode based on light emitted is preferably larger than 10 %. A sheet resistance of the anode is preferably several hundred Ω/□ or less. A film thickness of the anode is selected, though depending on the material, in a range of usually 10 nm to 1 µm, preferably 10 to 200 nm.

A cathode in the organic EL device assumes a role of injecting an electron into the electron injecting/transporting layer or the emitting layer, and metals, alloys, electroconductive compounds and mixtures thereof each having a small work function (4 eV or less) can be used as an electrode material. The specific examples of the above electrode materials include sodium, sodium-potassium alloys, magnesium, lithium, magnesium·silver alloys, aluminum/aluminum oxide, aluminum·lithium alloys, indium, rare earth metals and the like.
The cathode can be prepared by forming a thin film from the above electrode materials by a method such as vapor deposition, sputtering and the like. When light emitted from the emitting layer is taken out from the cathode, a transmittance of the cathode based on light emitted is preferably larger than 10 %. A sheet resistance of the cathode is preferably several hundred Ω/□ or less, and a film thickness thereof is usually 10 nm to 1µm, preferably 50 to 200 nm.

In general, an organic EL device is prepared on a light-transmissive substrate. The light-transmissive substrate referred to in this case is a substrate for supporting the organic EL device, and it is preferably a flat substrate in which light in a visible region of 400 to 700 nm has a transmittance of 50 % or more.
To be specific, it includes a glass plate, a polymer plate and the like. In particular, the glass plate includes soda lime glass, barium·strontium-containing glass, lead glass, aluminosilicate glass, borosilicate glass, barium borosilicate glass, quartz and the like. The polymer plate includes polycarbonate, acryl, polyethylene terephthalate, polyether sulfide, polysulfone and the like.

### EXAMPLES

Next, the present invention shall be explained below in further details with reference to examples, but the present invention shall by no means be restricted by the examples shown below.

### Example 1

A glass substrate (manufactured by Geomatech Co., Ltd.) of 25 mm × 75 mm × 1.1 mm thickness equipped with an ITO transparent electrode was subjected to supersonic wave washing in isopropyl alcohol for 5 minutes and then to UV ozone washing for 30 minutes. A film of polyethylenedioxythiophene · polystyrnesulfonic acid (PEDOT-PSS) used for a hole injecting layer was formed in a film thickness of 100 nm on the above substrate by a spin coating method. Then, a toluene solution (0.6 wt %) of a polymer 1 (molecular weight: 145000) shown below was coated thereon in a film thickness of 20 nm by the spin coating method to form a hole transporting layer, and it was dried at 170°C for 30 minutes.
Then, a film of a compound A was formed thereon as an emitting layer by vapor deposition. In this case, a compound B was vapor-deposited in a ratio of A : B = 40 : 2 (wt/wt) based on the compound A. In this regard, the emitting layer had a film thickness of 50 nm. A tris(8-quinolinol) aluminum film (hereinafter abbreviated as an Alq film) having a film thickness of 10 nm was formed on the above film. The above Alq film functions as an electron transporting layer. Then, Li (Li source: manufactured by Saesgetter Co., Ltd.) which was a reducing dopant and Alq were subjected to binary vapor deposition to form an Alq : Li film as an electron injecting layer (cathode). Metal Al was vapor-deposited on the above Alq : Li film to form a metal cathode, whereby an organic electroluminescence device was formed. This device emitted a blue light, and a voltage and a current efficiency (cd/A) at 100 cd/m² and a luminance half life at an initial luminance of 1000 cd/m² are shown in Table 1.

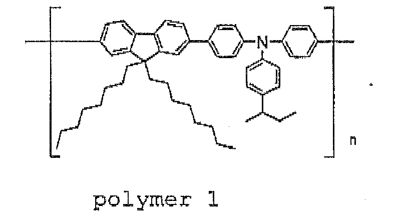

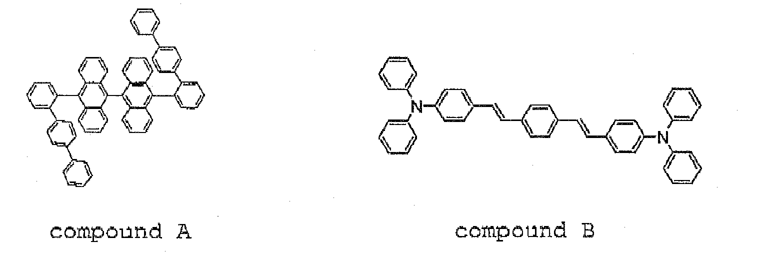

### Example 2

A device was prepared in the same manner as in Example 1, except that a polymer 2 (molecular weight: 14000) was used in place of the polymer 1. The results thereof are shown in Table 1.

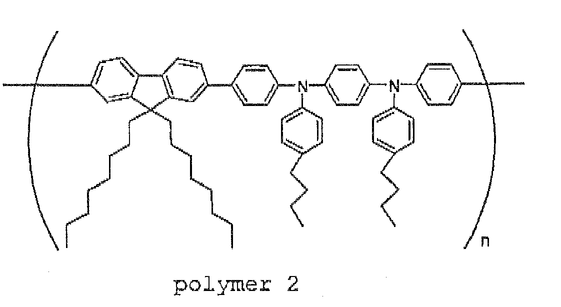

### Example 3

A device was prepared in the same manner as in Example 1, except that a polymer 3 (molecular weight: 50000) was used in place of the polymer 1. The results thereof are shown in Table 1.

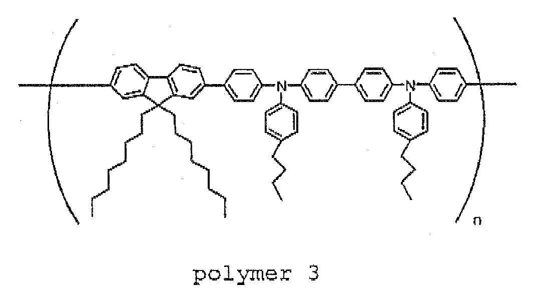

### Comparative Example 1

A device was prepared in the same manner as in Example 1, except that a polymer 4 (molecular weight: 270000) was used in place of the polymer 1. The results thereof are shown in Table 1.

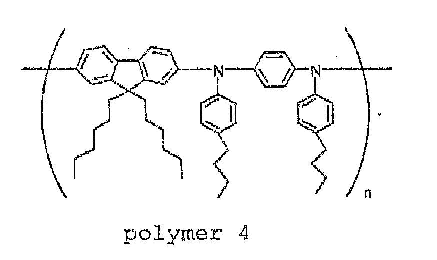

### Comparative Example 2

A device was prepared in the same manner as in Example 1, except that a polymer 5 (molecular weight: 16000) was used in place of the polymer 1. The results thereof are shown in Table 1.

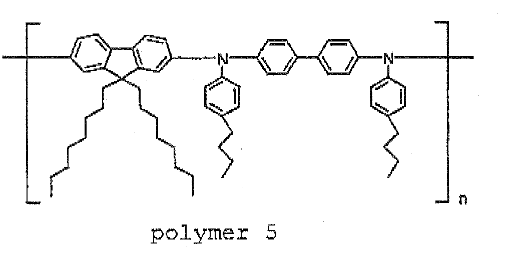

### Comparative Example 3

A device was prepared in the same manner as in Example 1, except that a polymer 6 (molecular weight: 43000) was used in place of the polymer 1. The results thereof are shown in Table 1.

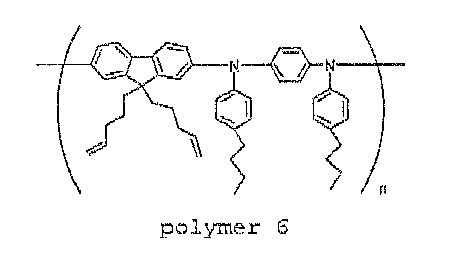

**Table 1**

| | Example | | | Comparative Example | | |
|---|---|---|---|---|---|---|
| | 1 | 2 | 3 | 1 | 2 | 3 |
| Polymer | 1 | 2 | 3 | 4 | 5 | 6 |
| Applied voltage (V) | 5.0 | 6.5 | 5 | 7.5 | 6 | 6.5 |
| Current efficiency (cd/A) | 11.2 | 6.0 | 9.2 | 3.2 | 5.7 | 2.3 |
| Luminance half life (hours) | 1050 | 350 | 500 | 150 | 10 | 230 |

### Example 4

A device was prepared in the same manner as in Example 1, except that a compound C was used in place of the compound A.
The results thereof are shown in Table 2.

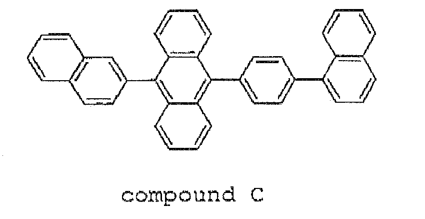

### Example 5

A device was prepared in the same manner as in Example 1, except that a compound D was used in place of the compound A. The results thereof are shown in Table 2.

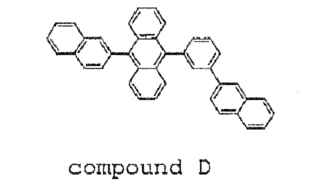

### Example 6

A device was prepared in the same manner as in Example 1, except that a compound E was used in place of the compound A. The results thereof are shown in Table 2.

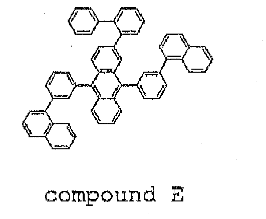

### Example 7

A device was prepared in the same manner as in Example 1, except that a compound F was used in place of the compound A. The results thereof are shown in Table 2.

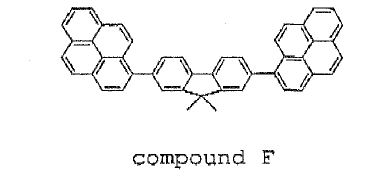

### Example 8

A device was prepared in the same manner as in Example 1, except that a compound G was used in place of the compound A. The results thereof are shown in Table 2.

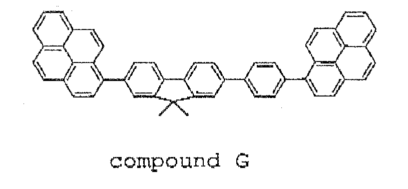

**Table 2**

| | Example | | | | |
|---|---|---|---|---|---|
| | 4 | 5 | 6 | 7 | 8 |
| Compound | C | D | E | F | G |
| Applied voltage (V) | 5.0 | 5.5 | 5.0 | 5.5 | 5.5 |
| Current efficiency (cd/A) | 11.2 | 10.3 | 9.8 | 11.0 | 8.9 |
| Luminance half life (hours) | 1500 | 1450 | 1000 | 1200 | 1100 |

### Example 9

A glass substrate (manufactured by Geomatech Co., Ltd.) of 25 mm × 75 mm × 1.1 mm thickness equipped with an ITO transparent electrode was subjected to supersonic wave washing in isopropyl alcohol for 5 minutes and then to UV ozone washing for 30 minutes. A film of polyethylenedioxythiophene· polystyrnesulfonic acid (PEDOT-PSS) used for a hole injecting layer was formed in a film thickness of 100 nm on the above substrate by a spin coating method. Then, a toluene solution (0.6 wt %) of the polymer 1 (molecular weight: 145000) described above was coated thereon in a film thickness of 20 nm by the spin coating method to form a hole transporting layer, and it was dried at 170°C for 30 minutes.
Then, a 1 wt % toluene solution of the compound A and the compound B (A : B = 20 : 2 (wt/wt)) was used to form an emitting layer by the spin coating method. In this regard, the film thickness was 50 nm. A tris(8-quinolinol)aluminum film (hereinafter abbreviated as an Alq film) having a film thickness of 10 nm was formed on the above film. The above Alq film functions as an electron transporting layer. Then, Li (Li source: manufactured by Saesgetter Co., Ltd.) which was a reducing dopant and Alq were subjected to binary vapor deposition to form an Alq : Li film as an electron injecting layer (cathode). Metal Al was vapor-deposited on the above Alq : Li film to form a metal cathode, whereby an organic electroluminescence device was formed. This device emitted a blue light, and a voltage and a current efficiency (cd/A) at 100 cd/m² and a luminance half life at an initial luminance of 1000 cd/m² are shown in Table 3.

### Example 10

A device was prepared in the same manner as in Example 9, except that the polymer 3 (molecular weight: 50000) was used in place of the polymer 1. The results thereof are shown in Table 3.

### Comparative Example 4

A device was prepared in the same manner as in Example 9, except that the polymer 4 (molecular weight: 270000) was used in place of the polymer 1. The results thereof are shown in Table 3.

**Table 3**

| | Example | | Comparative Example |
|---|---|---|---|
| | 9 | 10 | 4 |
| Polymer | 1 | 3 | 4 |
| Applied voltage (V) | 5-5 | 6.0 | 7.0 |
| Current efficiency (cd/A) | 5.6 | 4.8 | 1.2 |

### Example 11

A device was prepared in the same manner as in Example 9, except that the compound C was used in place of the compound A. In this regard, the device emitted a blue light and showed a voltage of 5.5 V and a current efficiency of 5.8 cd/A at 100 cd/m².

### Example 12

A device was prepared in the same manner as in Example 9, except that the compound E was used in place of the compound A. In this regard, the device emitted a blue light and showed a voltage of 5.5 V and a current efficiency of 5.2 cd/A at 100 cd/m².

### INDUSTRIAL APPLICABILITY

As explained above in details, the organic amine compound of the present invention has a high solubility and can form a film by a wet process, and an organic EL device obtained by using it assumes various light emitting hues and has a high heat resistance. In particular, use of the organic amine compound of the present invention as a hole injecting and transporting material elevates the hole injecting and transporting property, enhances the luminance and the luminous efficiency and elongates the lifetime. Accordingly, the organic EL device of the present invention is highly practical and useful as a light source for flat luminous bodies of wall-mounted TV and backlights of display.

## Claims

1. An organic electroluminescence device in which one or more organic compound layer comprising at least an emitting layer is interposed between a pair of electrodes constituted from an anode and a cathode, wherein the above organic compound layer comprises a hole transporting layer and/or a hole injecting layer, and polyarylamine represented by Formula (1) shown below is contained in the above hole transporting layer and/or hole injecting layer: 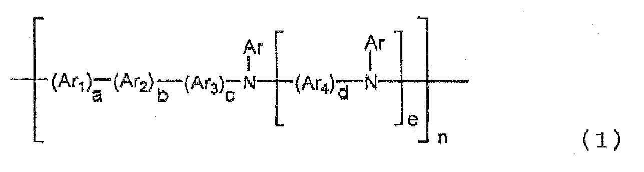 wherein Ar each is independently a substituted or non-substituted aryl group having 6 to 40 carbon atoms or a substituted or non-substituted heteroaryl group having 3 to 40 carbon atoms;
Ar₁ to Ar₄ each are independently a substituted or non-substituted divalent arylene group having 6 to 40 carbon atoms;
a, b, c and d each are independently an integer of 1 to 2; e is an integer of 0 to 2; and n is an integer of 3 or more.

2. The organic electroluminescence device as described in claim 1, wherein the hole transporting layer and/or the hole injecting layer described above contain principally polyarylamine described above.

3. The organic electroluminescence device as described in any of claims 1 to 2, wherein the emitting layer described above contains at least one selected principally from an anthracene derivative, a pyrene derivative and a fluorene derivative.

4. The organic electroluminescence device as described in claim 3, wherein the emitting layer described above contains a styrylamine compound and/or an arylamine compound.

5. The organic electroluminescence device as described in any of claims 1 to 4, wherein the hole transporting layer and/or the hole injecting layer described above are formed by a wet method, and the emitting layer described above is formed by the wet method.

6. The organic electroluminescence device as described in any of claims 1 to 4, wherein the hole transporting layer and/or the hole injecting layer described above are formed by the wet method, and the emitting layer described above is formed by vapor deposition.
